# EUROPEAN PATENT SPECIFICATION

(11) **EP 3 818 903 B1**
(45) Date of publication and mention of the grant of the patent: **20.07.2022**
(21) Application number: 19919742.7
(22) Date of filing: 19.12.2019
(51) Int. Cl.: A45D 20/12, H05K 5/02, H05K 7/20

(54) **HAIR DRIER WITH HIGH HEAT DISSIPATION EFFICIENCY**
HAARTROCKNER MIT HOHER WÄRMEABLEITUNG
SÈCHE-CHEVEUX À EFFICACITÉ DE DISSIPATION DE CHALEUR ÉLEVÉE

(30) Priority: 15.03.2019 CN 201910199571
(43) Date of publication of application: 12.05.2021
(73) Proprietor: KingClean Electric Co., Ltd., Suzhou New District Suzhou Jiangsu 215163 (CN)
(72) Inventor: NI, Zugen, Jiangsu 215163 (CN)
(74) Representative: Mewburn Ellis LLP
(86) International application number: PCT/CN2019/126728
(87) International publication number: WO 2020/186854

(56) References cited:
- EP-A1- 3 831 240
- CN-A- 106 880 155
- CN-A- 109 171 160
- CN-A- 109 259 408
- CN-A- 109 700 159
- CN-A- 109 743 859
- CN-U- 207 532 060
- CN-U- 209 982 903
- JP-A- H0 234 992
- JP-A- H09 224 736
- US-B1- 9 526 311

## Description

### TECHNICAL FIELD

The present disclosure relates to the technical field of home appliances, in particular, to a hair dryer with high heat dissipation efficiency.

### BACKGROUND

A hair dryer is a home appliance that uses a fan to rotate and blow out air to dry wet objects. A motor is used to drive the fan to rotate.

In order to improve product quality and improve user experience, the brushless motor is increasingly adopted by the motor of the current hair dryer. However, this type of hair dryer also has some disadvantages which are mainly in that: a main control board of the brushless motor generates heat seriously (mainly due to a metal oxide semiconductor (MOS) transistor arranged on the main control board). Moreover, it is not recommended to place the main control board directly in an air passage (placing the main control board in the air passage will cause noise to increase and turbulence to be generated in the inletting air). Thus, heat dissipation capability of the main control board is poor, which in turn renders working performance of the hair dryer unstable.

US 9526311 B1 discloses a hairdryer powered by a rechargeable lithium ion battery. The heat from the battery is directly used to heat the forced air created by the hairdryer fan. This is accomplished by situating the battery in the path of the forced air, or by connecting the battery to a heat sink and disposing at least part of the heat sink in the path of the forced air. The fan motor is situated in the path of the forced air. All circuitry within the hairdryer is either disposed in the path of the forced air, or thermally connected to the heat sink which is at least partially disposed in the path of the forced air. In this way, any heat created by the hairdryer's electrical components is used to preheat the forced air within the hairdryer. The preheated air is then further heated by the heating element within the hairdryer.

### SUMMARY

Aspects of the invention are set out in the appended claims. The present disclosure aims to provide a hair dryer with high heat dissipation efficiency of which a main control board has good heat dissipation effect.

The hair dryer with high heat dissipation efficiency according to the present disclosure is provided with the heat dissipating device made of thermally conductive material therein. The heat dissipating device is thermally connected to the heating component and is at least partially disposed in the air passage. Thus, the heat on the heat dissipating device may be taken away by the airflow whose temperature is lower than the temperature of the heat dissipating device, such as natural wind and the like. Therefore, the effect of heat dissipation for the heating component is achieved, and the problem that the main control board in the current hair dryer cannot dissipate heat well is solved.

### BRIEF DESCRIPTION OF THE DRAWINGS

FIG. 1 is a cross-sectional view of a hair dryer with high heat dissipation efficiency according to an embodiment of the present disclosure.
FIG. 2 is a first schematic view of a hair dryer with high heat dissipation efficiency according to an embodiment of the present disclosure.
FIG. 3 is a second schematic view of a hair dryer with high heat dissipation efficiency according to an embodiment of the present disclosure.
FIG. 4 is a schematic view of a heat dissipating device according to an embodiment of the present disclosure.

### DETAILED DESCRIPTION OF THE EMBODIMENTS

The technical solutions of the present disclosure will be further illustrated below in conjunction with the attached drawings and specific embodiments.

This embodiment discloses a hair dryer with high heat dissipation efficiency.

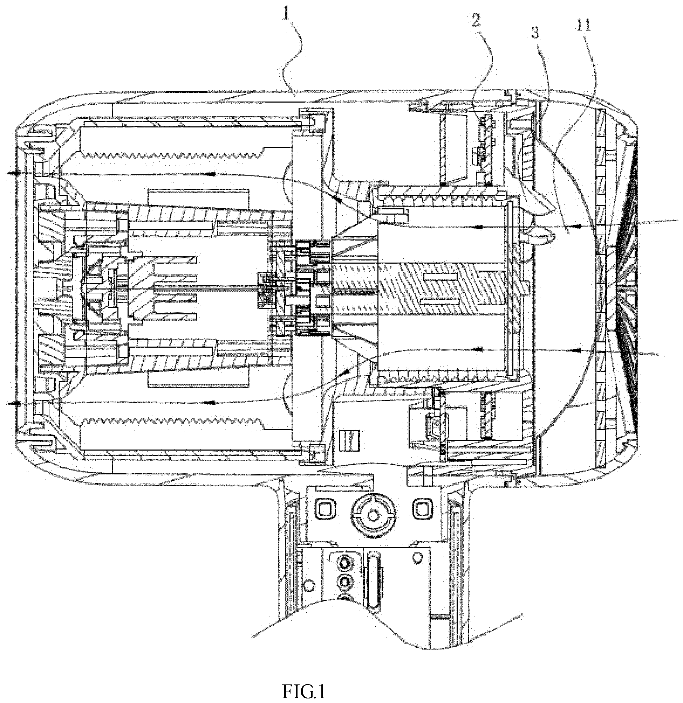

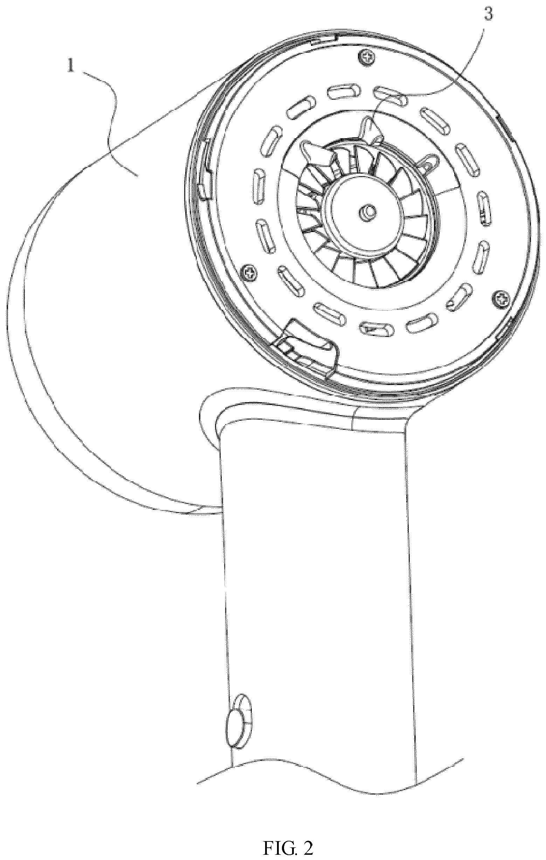

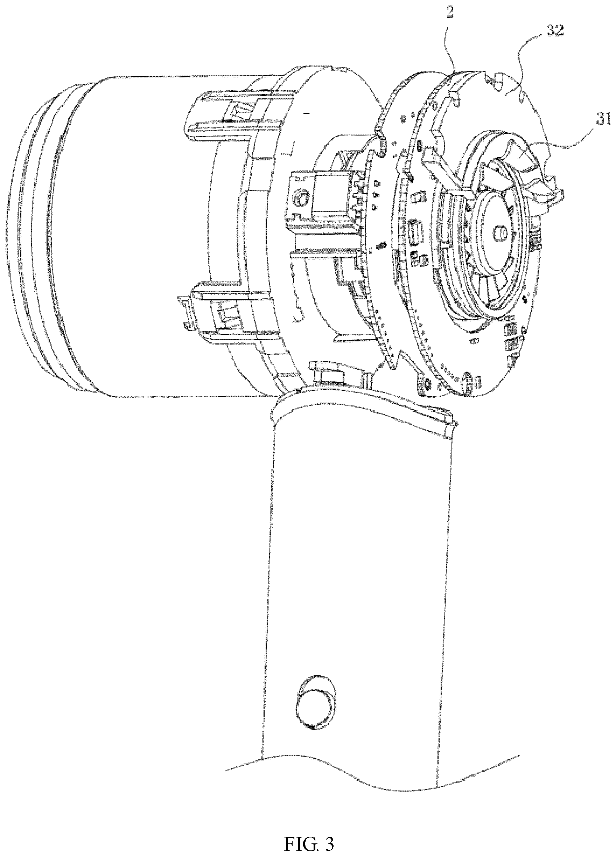

As shown in FIGS. 1 to 3, the hair dryer includes a body 1, a heating component 2 disposed in the body 1, and a heat dissipating device 3 made of thermally conductive material. The thermally conductive material may be, but is not limited to metal. An air passage 11 is formed in the body 1. The heating component 2 is located outside the air passage 11. The heat dissipating device 3 is thermally connected to the heating component 2 and is at least partially disposed in the air passage 11. The heating component 2 can be, but is not limited to, a main control board provided with heating elements such as metal oxide semiconductor (MOS) transistors and silicon controlled rectifiers, but not a heating wire used for heating airflow in a conventional hair dryer. The so-called "thermally connected" can be that the heat dissipating devices 3 is in direct contact with the heating component 2, or that the heat dissipating devices 3 is in indirect contact with the heating component 2 through other structures, as long as the heat can be conducted via these structures.

The heat dissipating device 3 is thermally connected to the heating component 2, and thus the heat on the heating component 2 can be transferred to the heat dissipating device 3. The heat dissipating device 3 is located in the air passage, and the heat on the heat dissipating device 3 is taken away by the airflow (such as natural wind and the like) whose temperature is lower than the temperature of the heat dissipating device 3, so that the effect of heat dissipation for the heating component 2 is achieved. That is, the heat dissipating device 3 serves as an auxiliary heat dissipating device of the heating component 2, which can conduct away the heat on the heating component 2 in a timely and efficient manner, ensuring that structures such as the main control board and the like can operate normally, and prolonging the service life of the product. The problem that the main control board in the current hair dryer cannot dissipate the heat well is solved.

In order to better dissipate heat, a plurality of groups of the heat dissipating devices 3 can be disposed along a direction of an inletting air. The plurality of groups of the heat dissipating devices 3 are thermally connected to different heating points on the heating component 2, respectively, and are respectively used for dissipating heat for the different heating points, so that the heat dissipation efficiency is higher. The heating points can be, but are not limited to, MOS transistors and silicon controlled rectifiers on the main control board.

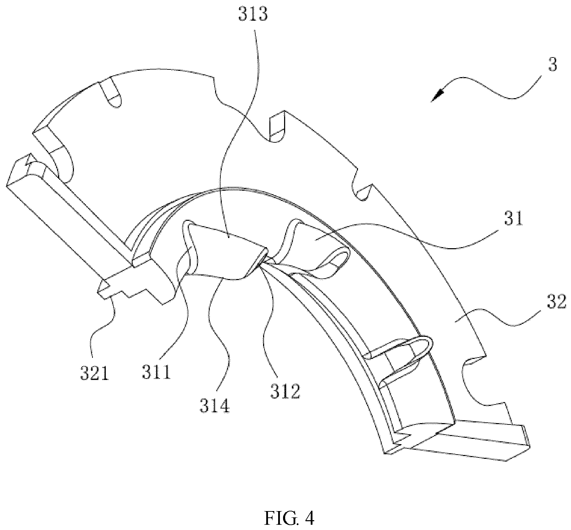

The specific structure of the heat dissipating device 3 is not limited. Preferably, as shown in FIG. 4, the heat dissipating device 3 includes a base 32 and a plurality of fins 31 disposed on the base 32. The fins 31 extend from the heating component 2 toward an air inlet end. Preferably, the fins 31 are disposed obliquely toward a direction of an incoming air, so as to reduce the airflow resistance and noise as much as possible while increasing the heat exchange area with the airflow. That is, a direction in which the fins 31 extend is opposite to the direction of the inletting air of the hair dryer, so that the fins 31 can be in contact with the airflow having a lower temperature and being at a more upstream position.

The fin 31 includes a bottom portion 311 away from the air inlet end, a top portion 312 adjacent to the air inlet end, a front side surface 313 at a windward side, and a rear side surface 314 at a leeward side. The fins 31 are disposed on the base 32 by the bottom portion 311 thereof, respectively, so that the structure of the fins 31 is more stable. The top portion 312 is consequentially in the air passage 11, and whether other structures are in the air passage 11 or not is determined according to actual usage requirements.

Along the direction of the inletting air, a distance between the top portion 312 and the bottom portion 311 gradually decreases. That is, the top portion 312 is a slope inclined along the direction of the inletting air, so that the airflow resistance may be reduced without affecting the heat dissipation, and the noise is reduced. The front side surface 313 is in an externally convex arched shape, that is, similar to a corrugated shape, so that the airflow is more smooth and stable when the inletting air blows over the front side surface 313, and the noise is lowered. A connection portion between the rear side surface 314 and the top portion 312 is an arc surface. That is, the rear side surface 314 and the top portion 312 are smoothly and transitionally connected with each other, which prevents the inletting air from being blocked at the connection portion between the rear side surface 314 and the top portion 312.

The base 32 is provided with a stepped surface 321. The stepped surface 321 is attached to the heating component 2, and thus the thermal conduction efficiency is high. In addition, the stepped surface 321 can also play a role of mutual limiting between the base 32 and the heating component 2.

The specific shape of the base 32 is not limited, as long as it can efficiently conduct heat for the heating component 2. Preferably, the base 32 is a sector-shaped structure aligned with the heating point on the heating component 2 or a ring-shaped sheet structure aligned with the heating component 2 as a whole. When the base 32 is ring-shaped, the heat dissipation area is large and the heat dissipation efficiency is high. When the base 32 is sector-shaped, it is small in volume and light in weight, which is beneficial to miniaturization and lightening of the hair dryer. Preferably, the base 32 is directly thermally connected to the heating points on the heating component 2, and thus the thermal conductivity efficiency is higher.

The base 32 not only can conduct heat at a portion attached to the heating component 2, but also can quickly conduct away the heat in a space around the heating component 2 at a portion not attached to the heating component 2, which also has the function of assisting the heating component 2 in heat dissipation.

On the basis of the above structure, a gap between the heat dissipating device 3 and the heating component 2 is filled with thermally conductive material, so that the heat dissipating device 3 and the heating component 2 are reliably thermally connected with each other, thus avoiding that the heat on the heating component 2 cannot be transferred to the heat dissipating device 3 due to the isolation of air. The thermally conductive material can be, but is not limited to, thermally conductive silicone grease, as long as it can ensure an efficient heat transfer.

It is noted that the above contents are only the preferred embodiments of the present disclosure and the technical principles applied. Those skilled in the art will understand that the present disclosure is not limited to the specific embodiments described herein. Various obvious changes, readjustments and substitutions can be made by those skilled in the art, without departing from the protection scope of the present disclosure. The scope of the present disclosure shall subject to the scope of the appended claims.

## Claims

1. A hair dryer with high heat dissipation efficiency, comprising a body (1) formed with an air passage (11) therein and a heating component (2) disposed in the body (1), wherein the hair dryer further comprising a heat dissipating device (3) made of thermally conductive material, the heating component (2) being located outside the air passage (11), the heat dissipating device (3) being thermally connected to the heating component (2) and being at least partially disposed in the air passage (11);
wherein the heat dissipating device (3) comprises a plurality of fins (31) extending from the heating component (2) toward an air inlet end, the heat dissipating device (3) further comprises a base (32), and the fins (31) are disposed on the base (32) by bottom portions (311) thereof, respectively;
**characterized in that**:
the base (32) is either:
in a sector shape, wherein the base (32) is aligned with heating points on the heating component (2); or
in a ring shape, wherein the base (32) is aligned with the heating component (2) as a whole.

2. The hair dryer with high heat dissipation efficiency according to claim 1, comprising a plurality of groups of the heat dissipating devices (3), the plurality of groups of the heat dissipating devices (3) being thermally connected to different heating points on the heating component (2), respectively.

3. The hair dryer with high heat dissipation efficiency according to claim 1, wherein each of the fins (31) comprises a top portion (312) in the air passage (11), a front side surface (313) at a windward side, and a rear side surface (314) at a leeward side, and
wherein the top portion (312) is a slope, the front side surface (313) is in an externally convex arched shape, and a connection portion between the rear side surface (314) and the top portion (312) is an arc surface.

4. The hair dryer with high heat dissipation efficiency according to claim 1, wherein the base (32) is thermally connected to the heating points on the heating component (2).

5. The hair dryer with high heat dissipation efficiency according to any one of claims 1 to 4, wherein the base (32) is provided with a stepped surface (321) thereon, and the stepped surface (321) is attached to the heating component (2).

6. The hair dryer with high heat dissipation efficiency according to any one of claims 1 to 5, wherein a gap between the heat dissipating device (3) and the heating component (2) is filled with thermally conductive material.

7. The hair dryer with high heat dissipation efficiency according to any one of claims 1 to 6, wherein the heating component (2) is a metal oxide semiconductor (MOS) transistor and/or a silicon controlled rectifier.

## Patentansprüche

1. Haartrockner mit hoher Wärmeableitungseffizienz, der einen Körper (1), der mit einem Luftkanal (11) darin ausgebildet ist, und eine Heizkomponente (2), die in dem Körper (1) angeordnet ist, umfasst, wobei der Haartrockner außerdem eine Wärmeableitungsvorrichtung (3) umfasst, die aus einem wärmeleitenden Material hergestellt ist, wobei die Heizkomponente (2) außerhalb des Luftkanals (11) angeordnet ist, die Wärmeableitungsvorrichtung (3) mit der Heizkomponente (2) thermisch in Verbindung ist und zumindest teilweise in dem Luftkanal (11) angeordnet ist;
wobei die Wärmeableitungsvorrichtung (3) eine Vielzahl von Lamellen (31) umfasst, die sich von der Heizkomponente (2) in Richtung eines Lufteinlass-Endes erstrecken, die Wärmeableitungsvorrichtung (3) außerdem eine Grundplatte (32) umfasst und die Lamellen (31) durch entsprechende Bodenabschnitte (311) derselben auf der Grundplatte (32) angeordnet sind;
**dadurch gekennzeichnet, dass**:
die Grundplatte (32) entweder:
eine Sektorform aufweist, bei der die Grundplatte (32) mit Heizpunkten auf der Heizkomponente (2) fluchtend ausgerichtet ist; oder
eine Ringform aufweist, bei der die Grundplatte (32) mit der Heizkomponente (2) als Ganzes fluchtend ausgerichtet ist.

2. Haartrockner mit hoher Wärmeableitungseffizienz nach Anspruch 1, der eine Vielzahl von Gruppen der Wärmeableitungsvorrichtungen (3) umfasst, wobei die Vielzahl von Gruppen der Wärmeableitungsvorrichtungen (3) mit verschiedenen Heizpunkten auf der Heizkomponente (2) entsprechend thermisch in Verbindung ist.

3. Haartrockner mit hoher Wärmeableitungseffizienz nach Anspruch 1, wobei jede der Lamellen (31) einen oberen Abschnitt (312) im Luftkanal (11), eine Vorderseitenfläche (313) auf der Luvseite und eine Hinterseitenfläche (314) auf der Leeseite aufweist, und
wobei der obere Abschnitt (312) eine Schräge ist, die Vorderseitenfläche (313) eine nach außen gebogene, konvexe Form aufweist und ein Verbindungsabschnitt zwischen der Hinterseitenfläche (314) und dem oberen Abschnitt (312) eine Bogenfläche ist.

4. Haartrockner mit hoher Wärmeableitungseffizienz nach Anspruch 1, wobei die Grundplatte (32) mit den Heizpunkten auf der Heizkomponente (2) thermisch in Verbindung ist.

5. Haartrockner mit hoher Wärmeableitungseffizienz nach einem der Ansprüche 1 bis 4, wobei die Grundplatte (32) mit einer darauf ausgebildeten abgestuften Fläche (321) bereitgestellt ist und die abgestufte Fläche (321) an der Heizkomponente (2) befestigt ist.

6. Haartrockner mit hoher Wärmeableitungseffizienz nach einem der Ansprüche 1 bis 5, wobei ein Spalt zwischen der Wärmeableitungsvorrichtung (3) und der Heizkomponente (2) mit einem wärmeleitenden Material gefüllt ist.

7. Haartrockner mit hoher Wärmeableitungseffizienz nach einem der Ansprüche 1 bis 6, wobei die Heizkomponente (2) ein Metalloxid-Halbleiter- (MOS-) Transistor und/oder ein siliziumgesteuerter Gleichrichter ist.

## Revendications

1. Sèche-cheveux à efficacité de dissipation de chaleur élevée, comprenant un corps (1) formé avec un passage d'air (11) en son sein et un composant chauffant (2) disposé dans le corps (1), dans lequel le sèche-cheveux comprend en outre un dispositif de dissipation de chaleur (3) constitué d'un matériau thermiquement conducteur, le composant chauffant (2) étant situé à l'extérieur du passage d'air (11), le dispositif de dissipation de chaleur (3) étant connecté thermiquement au composant chauffant (2) et étant au moins partiellement disposé dans le passage d'air (11) ;
dans lequel le dispositif de dissipation de chaleur (3) comprend une pluralité d'ailettes (31) s'étendant depuis le composant chauffant (2) vers une extrémité d'entrée d'air, le dispositif de dissipation de chaleur (3) comprend en outre une base (32), et les ailettes (31) sont disposées sur la base (32) par des parties inférieures (311) de celles-ci, respectivement ;
**caractérisé en ce que** :
la base (32) est :
en une forme de secteur, la base (32) est alignée avec des points de chauffage sur le composant chauffant (2) ; ou
en une forme d'anneau, la base (32) étant alignée avec le composant chauffant (2) dans son ensemble.

2. Sèche-cheveux à efficacité de dissipation de chaleur élevée selon la revendication 1, comprenant une pluralité de groupes des dispositifs de dissipation de chaleur (3), la pluralité de groupes des dispositifs de dissipation de chaleur (3) étant reliée thermiquement à différents points de chauffage sur le composant chauffant (2), respectivement.

3. Sèche-cheveux à efficacité de dissipation de chaleur élevée selon la revendication 1, dans lequel chacune des ailettes (31) comprend une partie supérieure (312) dans le passage d'air (11), une surface latérale avant (313) au niveau d'un côté au vent, et une surface latérale arrière (314) au niveau d'un côté sous le vent, et
dans lequel la partie supérieure (312) est une pente, la surface latérale avant (313) est dans une forme arquée convexe extérieurement, et une partie de connexion entre la surface latérale arrière (314) et la partie supérieure (312) est une surface arquée.

4. Sèche-cheveux à efficacité de dissipation de chaleur élevée selon la revendication 1, dans lequel la base (32) est reliée thermiquement aux points de chauffage sur le composant chauffant (2).

5. Sèche-cheveux à efficacité de dissipation de chaleur élevée selon l'une quelconque des revendications 1 à 4, dans lequel la base (32) est pourvue d'une surface étagée (321) sur celle-ci, et la surface étagée (321) est fixée au composant chauffant (2).

6. Sèche-cheveux à efficacité de dissipation de chaleur selon l'une quelconque des revendications 1 à 5, dans lequel un espace entre le dispositif de dissipation de chaleur (3) et le composant chauffant (2) est rempli d'un matériau thermiquement conducteur.

7. Sèche-cheveux à efficacité de dissipation de chaleur selon l'une quelconque des revendications 1 à 6, dans lequel le composant chauffant (2) est un transistor métal-oxyde-semi-conducteur (MOS) et/ou un redresseur commandé au silicium.
